(19) Europäisches Patentamt
European Patent Office
Office européen des brevets

(11) **EP 2 905 894 B1**

(12) **EUROPEAN PATENT SPECIFICATION**

(45) Date of publication and mention
of the grant of the patent:
**17.05.2017 Bulletin 2017/20**

(21) Application number: **15151578.0**

(22) Date of filing: **19.01.2015**

(51) Int Cl.:
*H04B 1/04* (2006.01)          *H04B 7/06* (2006.01)
*H04L 27/20* (2006.01)        *H03D 7/14* (2006.01)
*H03D 7/16* (2006.01)

(54) **A modulation circuit for a radio device and a method thereof**

Modulationsschaltung für eine Funkvorrichtung und Verfahren dafür

Circuit de modulation pour un dispositif radio et procédé associé

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **06.02.2014 EP 14154137**

(43) Date of publication of application:
**12.08.2015 Bulletin 2015/33**

(73) Proprietor: **IMEC VZW
3001 Leuven (BE)**

(72) Inventors:
• **Guermandi, Davide
3001 Leuven (BE)**
• **Giannini, Vito
3001 Leuven (BE)**
• **Van Thillo, Wim
3001 Leuven (BE)**
• **Bourdoux, André
3001 Leuven (BE)**

(74) Representative: **Patent Department IMEC
IMEC vzw
Patent Department
Kapeldreef 75
3001 Leuven (BE)**

(56) References cited:
**EP-A2- 0 070 695          EP-A2- 0 417 528
US-A- 5 787 126             US-A1- 2005 068 096
US-A1- 2006 019 622**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### Technical field

The present disclosure relates to radio devices operating at mm-waves and more specifically to a modulation circuit for such radio devices.

### Background

Signal modulation is an operation that changes some of the properties (such as amplitude, frequency, phase or any combination of them) of a high frequency sine wave signal, called a carrier signal, as a function of another signal, called a modulating signal. Because the carrier is commonly at a much higher frequency of the modulating signal this operation is also called up-conversion.

The most common architecture used to modulate signal to high frequency (e.g. from a few MHz to tens of GHz) is the Gilbert cell mixer, that acts as a multiplier of its two inputs. It essentially multiplies a modulating signal (e.g. a digital signal) applied at its first input with a carrier signal (or a local oscillator signal) applied at its second input to modulate the carrier signal according to the binary data. Usually, the modulating signal is applied at its linear input which performs a voltage to current conversion, while the signal to be modulated - the carrier signal - is applied to its nonlinear input (also called switching input). Driving the mixer's non-linear input with a local oscillator (a very high frequency) signal requires the amplitude of the latter to be sufficiently high to be able to drive the switching input under any process, voltage and temperature (PVT) variations and hence leads to high power consumption. For power efficient modulation, known solutions propose swapping the signals applied at the two inputs of the mixer. Applying the local oscillator signal to the linear input of the mixer, allows using a local oscillator signal with small amplitude and thus reducing the power consumption of the mixer.

If the modulating signal is a digital signal (i.e. a binary sequence), the modulated signal is the multiplication of the carrier signal by +1 or -1 depending on the bit sign. This type of modulation is called Binary Phase Shift Keying (BPSK). Without taking any counter measure, the full spectrum of the digital signal, or all frequency components the digital signal consists of including its respective high-frequency components (its side lobes), are up-converted. However, the side lobes at high frequency may be not compatible with the spectral emission mask requirements, such as ESTI specification for 79 GHz radar applications, specifying energy requirements to the frequency components located around an intended operational bandwidth. This issue is explained in more details below.

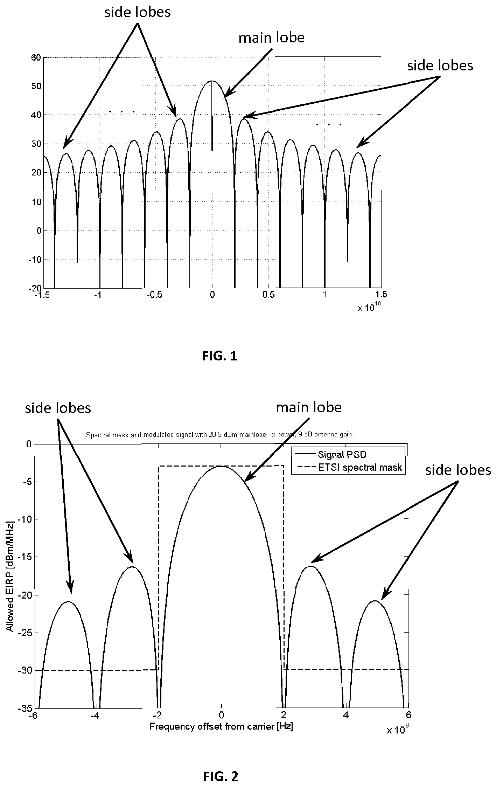

In a perfect BPSK modulation the high frequency carrier is multiplied by +1 or -1 depending on the modulating bit. This means the output is a sine wave with phase either 0 or 180 degrees (i.e. 0 or $\pi$). This instantaneous phase jumps introduce discontinuity in the waveform of the modulated signal, that are translated in a wide frequency spectrum with respect to the single tone of the carrier signal, as shown in FIG.1, causing side lobes to appear around the carrier tone. The first side lobe corresponds to the 3-rd harmonic, the second one to the 5-th harmonic and so forth. The power of the side lobes located around the main lobe (or i.e. the intended operational bandwidth) decrease as:

$$\left(\frac{\sin(x)}{x}\right)^2, \; x = \pi\frac{f}{fs} \tag{1}$$

, where f is the offset frequency from the carrier on the x axis and fs is the sampling frequency of the baseband signal (i.e. 2 GHz in FIG.1).

Since the power of the side lobes (i.e. their respective energy content) decreases as shown in (1), their amplitude with respect to the main lobe can be computed in dB as

$$P_n = -20\log_{10}\frac{2}{\pi(2n+1)} \tag{2}$$

, where n is the number of the side lobe.

From the above equation could be derived that the 1st and the 2nd side lobes have a power of -13.4dB and -17.9dB with respect to the main lobe and thus not compliant with the emission specification as set by the ETSI standardization bodies. For example for radar applications in the 79GHz band, ETSI emission specification allows side lobes with -27dB lower than the power of the main lobe, as shown in FIG.2.

To comply with the emission mask requirements, conventional solutions opt for either reducing the peak transmitted power with additional 13.6dB (27-13.4dB), or for filtering the side lobes.

Some known solutions propose reduction of the harmonic content, caused by the baseband signal, by filtering the signal at the modulator output-filtering at radio frequency (RF). To achieve a substantial suppression of the side lobes at such high frequency, however, requires a higher order band-pass filter with a high quality factor Q (higher than the ratio of the required center frequency to required bandwidth). As for radar application, a radio should operates at 80GHz within a 4GHz-wide bandwidth, a 2nd order band-pass filter (BPF) with a quality factor Q of at least 20 (i.e. 80GHz/4GHz) is required. Realizing an RF BPF with such high quality factor, a good control on the center frequency and the bandwidth is practically impossible in a standard CMOS technology. External filters with lumped or distributed components may be used, but this would unavoidably lead to extra cost and most likely losses. Such solutions are therefore not practical, nor cost-effective for applications at very high frequencies - frequencies above 5-10 GHz.

Other solutions propose reduction of the side lobes by filtering the high frequency content of the baseband signal prior its up-conversion by the modulator. A baseband (BB) filter smoothes the transitions of the baseband waveform from "0" to "1", leading to a smoother phase transition from 0 to 180 degrees in the waveform at the modulator output. However, filtering the baseband signal is only effective in reducing the distant side lobes, but not efficient in reducing the most critical side lobes - the ones closest to the main lobe. Using higher order BB filters may be more efficient in the reduction of the critical side lobes, but they require the use of active components (such as transistors, transconductors, operational amplifiers) or inductors to generate complex conjugate poles for a sharper response and thus leading to higher power consumption and a circuit complexity.

Harmonic Rejection (HR) is a technique used for the rejection of harmonics caused by the local oscillator signal during the mixing operation. The HR technique allows for suppression of the LO's side lobes corresponding to: (i) the third, (ii) the third and the fifth, and (iii) the third, the fifth and the seventh harmonics, depending on the complexity of the applied harmonic rejection. The higher harmonics to be suppressed, the more complex the modulator and the LO (clock) circuit. Harmonic rejection technique requires the input signal to be multiplied with copies of the local oscillator signal having different delays (phase) and weights (amplitude). By choosing the delays and weights properly, the summation of the mixers outputs results in cancelation of the harmonics caused by the local oscillator signal. The HR technique however is not applicable for devices operating at millimeter waves where power consumption, area and circuit complexity is of high importance as the complexity of the systems employing harmonic rejection grows exponentially with the number of harmonic order to be cancelled.

In paper "A 79GHz SiGe-Bipolar Spread-Spectrum TX for Automotive Radar" (S. Trotta et al, IEEE Solid-State Circuits Conference, 2007, pp.430-613, 11-15 Feb. 2007), Trotta et al proposes a bi-phase modulator utilizing a Gilbert-cell mixer for short-range automotive radar applications in the mixer. However, the architecture suffers from high side lobes and fails to comply with the emission regulations.

In "Sinusoidal SBPSK Modulation Waveform for UHF SATCOM Channels with Improved Adjacent Channel Emissions" (M.A. Belkerdid et al, IEEE Military Communications Conference, pp.1-7, 29-31 Oct. 2007), Belkerdid et al proposes a method for reduction of the side-lobes of a BPSK modulation by splitting the baseband binary signal to I and Q signals and applying a non-linear phase shaping to I and Q signals prior to their modulation. This, results in a modulated carrier with a sinusoidal phase transition from 0 to $\pm$ 180 degrees over a time interval less that the bit period. Patent documents US5787126, US2005/068096, EP0417528, EP0070695 and US 2006/019622 disclose quadrature transmitter or receiver architectures wherein a phase-shifter or delay circuit is used in one of the signal branches.

## Summary

The present disclosure aims at providing a modulation circuit for radio devices operating at mm-waves and more specifically to a modulation circuit for BPSK modulation.

The present disclosure relates to a modulation circuit. According to an embodiment the circuit is configured to: receive a digital baseband signal and feed the same digital baseband signal to a first and a second signal path, the first signal path comprising a first mixing means, the second signal path comprising a delay circuit arranged for delaying the digital baseband signal and a second mixing means, the first and the second mixing means receiving a same local oscillator signal, and respectively providing a first and a second radio frequency signal with a delay with respect to each other; and generate a radio frequency signal by combining the first and second radio frequency signals, wherein the delay circuit has a delay of one third of a bit period of the digital baseband signal.

In another embodiment, each signal path further comprises filtering means configured to output a first and a second filtered baseband signals with a delay with respect to each other. In a preferred embodiment, the filtering means are a passive low-pass filter. For example, an RC filter may be used implemented in a passive form, which is also more linear and less noisy than implementation in active forms.

In another embodiment, the first and the second mixing means are configured to receive respectively a first and a second filtered baseband signal at its non-linear input and the same local oscillator signal at its linear input. In a preferred embodiment, the first and the second mixing means are passive mixing means.

In a further embodiment, the circuit is configured to perform a BPSK modulation.

In another embodiment, the circuit is configured to operate at millimeter waves.

Advantageously, according to an exemplary embodiment, it is possible to attenuate the amplitude of side lobes in a modulated radio frequency signal caused by a high frequency content in the baseband signal, while keeping the maximum possible power of the modulated signal within the allowed band, with a minimal hardware and power overhead. Spectral emission within the allowed bandwidth is reduced sufficiently and complies with the emission regulations. As the harmonic rejection is applied at baseband, there is no increase in circuit complexity in the LO path. Further, no complex hardware such as I and Q mixers per signal path, nor a complex baseband or RF filters are required. The digital baseband BB signal is applied to two signal paths which are essentially kept the same with the only difference that in one of them the baseband signal is delayed. According to an embodiment, by applying a harmonic rejection only for the 3rd harmonic - the highest and closest side lobe to the main lobe - the added complexity cost in the signal path is kept limited. According to another exemplary embodiment, a simple baseband filtering and a harmonic reduction at baseband is achieved. As the energy of the harmonics lessens with their order, the rejection of the 3rd harmonic only with baseband filtering applied for further reduction of the side lobes proves sufficient to comply with the emission regulations. The filtering at baseband does not require higher order filtering that is power hungry for devices operating in the Gb/s range.

The present disclosure also relates to a modulation method comprising: receiving a digital baseband signal; mixing the digital baseband signal with a local oscillator signal thereby generating a first radio frequency signal; delaying and mixing the same digital baseband signal with the local oscillator signal thereby generating a second radio frequency signal; and generating a radio frequency signal by combining the first and second radio frequency signals, wherein the step of delaying comprises delaying with a delay of one third of a bit period of the digital baseband signal.

In one embodiment, the method further comprising filtering the digital baseband signal (BB) before mixing with the local oscillator signal.

Furthermore, the present disclosure relates to a radio device and a network system comprising a modulation circuit according to the present disclosure.

## Brief description of the drawings

For a better understanding of the present disclosure, some exemplary embodiments are described below in conjunction with the appended figures and figures description, wherein:

FIG.1 illustrates one example of a BPSK spectrum.

FIG.2 illustrates another example of a BPSK spectrum with indicated ETSI spectral mask.

FIG.3 illustrates a block diagram of a modulation circuit according to an exemplary embodiment of the present disclosure.

FIG.4 illustrates, according to an exemplary embodiment, the first and second baseband signals at the input of the baseband filters and at the input of the mixers, respectively.

FIG.5A illustrates the spectrum of a pure BPSK signal.

FIG.5B illustrates the spectrum of a BPSK signal with harmonic rejection at BB according to an exemplary embodiment of the present disclosure.

FIG.5C illustrates the spectrum of a BPSK signal with harmonic rejection at BB and BB filtering according to an exemplary embodiment of the present disclosure.

FIG.6 illustrates the waveforms of the BPSK signals shown in FIGS. 5A, 5B and 5C, respectively.

FIG.7 illustrates, according to an exemplary embodiment, an implementation of a delay circuit.

FIG.8 illustrates, according to an exemplary embodiment, an implementation of a low-pass filter.

FIG.9 illustrates, according to an exemplary embodiment, an implementation of a Gilbert-cell mixer.

FIG.10 illustrates, according to an exemplary embodiment, a modulated BPSK signal generated by a modulation circuit according to the present disclosure.

FIG.11 illustrates, according to an exemplary embodiment, the spectrum of the modulated BPSK signal shown in FIG.10.

## Detailed description

The present disclosure will be described with respect to particular embodiments and with reference to certain drawings but the disclosure is not limited thereto. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting of only components A and B. It means that with respect to the present disclosure, the only relevant components of the device are A and B.

The present disclosure advantageously provides harmonic rejection (HR) at baseband for the suppression of the spectrum occupancy of a modulated RF signal. Conventional HR techniques are not applied for devices operating at millimeter waves due to their complexity and power consumption. According to the present disclosure, however, the resulting harmonic content in the modulated signal is not due to the harmonics of the oscillator signal but to the wide spectrum of the baseband signal, which is a digital signal. The harmonics of the baseband digital signal, that appears in the form of side lobes in the modulated radio frequency signal, as previously described, are of a great concern for the spectral emission of devices operating at millimeter waves. The present disclosure herein described applies the harmonic rejection concept to a baseband signal (a binary sequence in this case) rather than to a local oscillator signal as in conventional HR techniques, leading to the suppression of the harmonics (side lobes) caused by the baseband signal in the modulated RF signal.

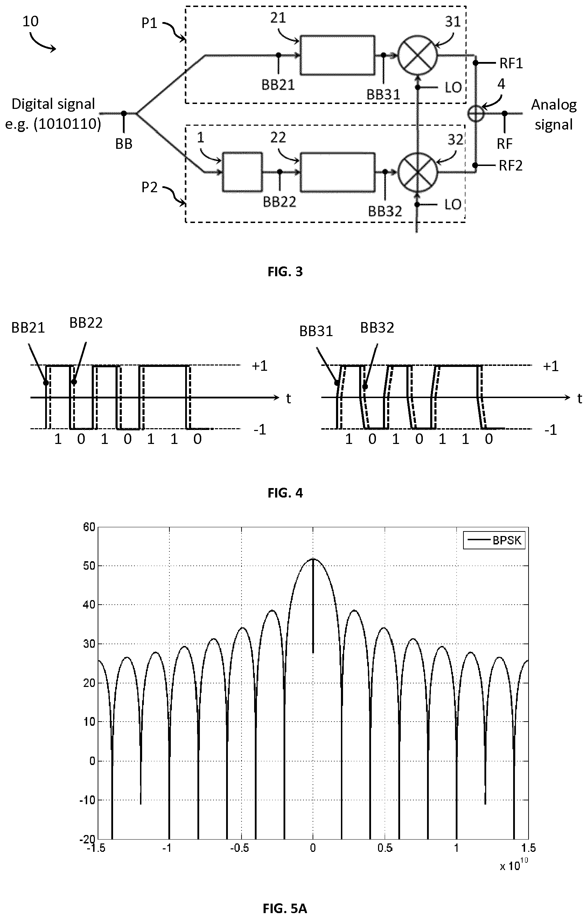

According to an exemplary embodiment, a modulation circuit 10 is arranged for suppressing energy content of the spectral components outside an intended operational bandwidth of a modulated radio frequency signal RF, as shown in FIG.3. The proposed circuit uses harmonic rejection at baseband. A digital baseband BB signal is applied to two signal paths P1,P2 wherein a delay is applied to create two baseband signals BB21,BB22 with phases rotated with respect to each other, as shown in FIG.4. To suppress the high energy of the side lobes in the modulated radio frequency signal RF, due to high frequency components in the baseband signals, the baseband signals BB31,BB32 are up-converted by the mixers 31,32. The up-converted signals RF1,RF2 are recombined at the output of circuit 10 to form a modulated signal RF.

In more details, the circuit 10 is configured to receive a digital baseband signal BB and to generate a radio frequency signal RF. The circuit 10 comprises two signal paths P1,P2 which are fed with the same baseband signal BB (e.g. 1010110). The first signal path P1 comprises a first mixing means 31. The second signal path P2 comprises a delay circuit 1 and a second mixing means 32. The implementation of the two signal paths are essentially kept the same, with the difference that in the second signal path the baseband signal BB is delayed with respect to the other. The baseband signal in the signal path P2 is first delayed by the delay circuit 1 and then passed for further processing. The baseband signals BB31,BB22 are then fed to the respective mixing means 31,32 and up-converted with the same local oscillator signal LO. As a result, two modulated radio signals, a first and a second radio frequency signals RF1,RF2, with phases rotated with respect to each other are generated. The signals RF1,RF2 are then combined in an adder circuit 4 to produce the radio frequency signal RF. By combining two same up-converted signals RF1,RF2 but with a phase shift with respect to each other, the circuit 10 eliminates a harmonic in the resulting RF signal.

In one embodiment, to further reduce the high frequency content in the baseband signals BB21,BB22, the baseband signal BB21,BB22 in each respective signal path may be filtered by the respective filtering means 21,22 prior up-conversion. In this embodiment, two filtered baseband signals BB31,BB32 are thus created. Similarly to the previous embodiment, the filtered baseband signals BB31,BB22 are then fed to the respective mixing means 31,32 and up-converted with the same local oscillator signal LO. As a result, two modulated radio signals, a first and a second radio frequency signals RF1,RF2, with phases rotated with respect to each other are generated. The signals RF1,RF2 are then combined in an adder circuit 4 to produce the radio frequency signal RF. The applied baseband filtering guarantees the side lobes in the modulated RF signal at the output of the circuit are within the emission regulation.

FIG.4 shows the respective baseband signal in each signal path before and after filtering. Before filtering, the baseband signals BB21 and BB22 are delayed with respect to each other. After filtering, the signals BB31,BB32 are smoothed - the waveform of the signals transitions from +1 to -1 and vice versa in a smoother manner.

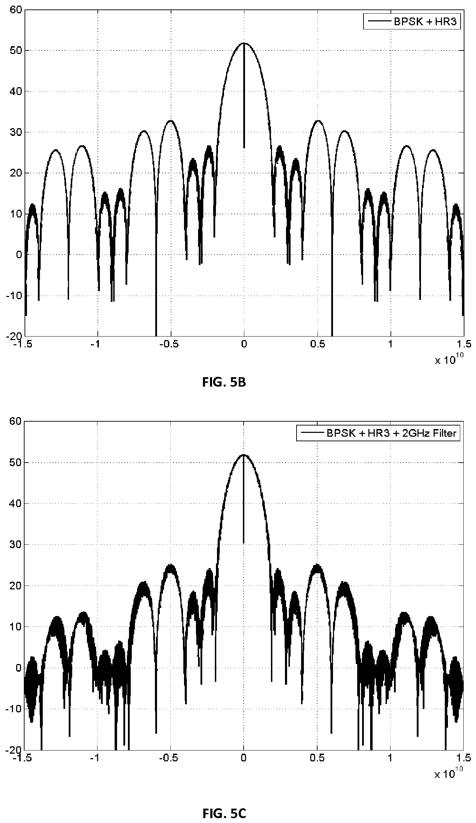

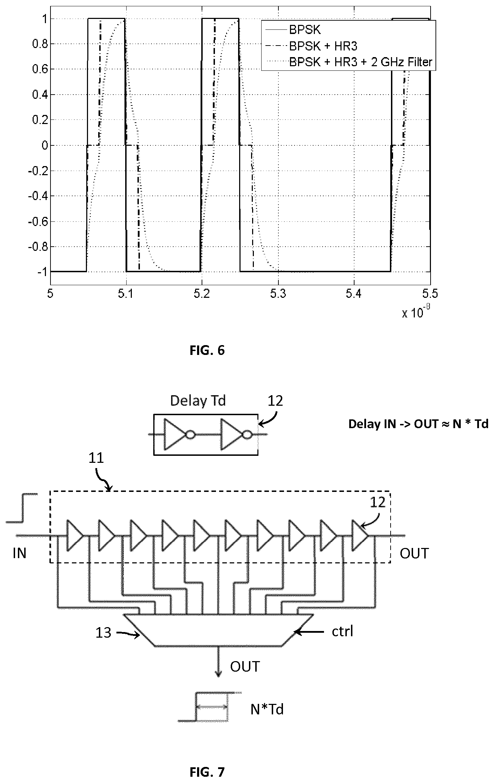

FIG.5 shows, respectively, an example of a BPSK spectrum for pure BPSK modulation, a BPSK modulation with 3rd harmonic rejection and a BPSK modulation with 3rd harmonic rejection and baseband filtering, as according to the present disclosure. In comparison to a pure BPSK signal shown in FIG.5A, applying $3^{rd}$ harmonic rejection at baseband significantly suppresses the side lobes, while preserving the energy of the main lobe (see FIG.5B). In addition, the side lobes corresponding to the (n*3)th harmonic are also suppressed. The proposed harmonic rejection results in suppression of the energy content of the side lobes in the spectrum of the baseband signal, instead of the LO as in conventional harmonic rejection solutions. To guarantee complying with the emission regulation, additionally baseband filtering may be applied with harmonic rejection as shown in FIG.5C. FIG.6 shows the resulting modulated signal for the three different modulation schemes shown in FIG.5. It is noticeable that the application of harmonic rejection at baseband smoothes the transition edges in the modulated signal to a staircase waveform of the phase transition from 0 to 180 degrees and vice versa. In combination with BB filtering (i.e. 2GHz filter, a LPF filter with a cutoff frequency at 2 GHz), the staircase waveform is further smoothed, which results in further lowering the energy content in the spectrum of the modulated signal.

In another embodiment, the delay circuit 1 delays the baseband signal BB with a delay of 1/3 of the bit period of the baseband signal. Thus, the baseband signals in the two signal paths are delayed with respect to each other, having phases rotated over 0 and 120 degrees, respectively. Delaying the baseband signal in the second signal path with 1/3 of the bit period, achieves the best result in canceling the $3^{rd}$ harmonic in the modulated radio frequency signal RF. Thus, the $3^{rd}$ harmonic caused by the high frequency content of the baseband signal and corresponding to the first side lobe - the highest and the closest side lobe to the main lobe - in the frequency spectrum of the RF signal is removed. However, the skilled person will recognize that delaying the baseband signal with a bigger or a smaller than 1/3 of the bit period delay is also beneficial. In this case, the $3^{rd}$ harmonic will not be completely removed. To comply with the emission regulation, however, additional side lobes' suppression may be achieved by applying baseband filtering as according to the present disclosure.

An example implementation of the delay circuit 1 arranged for receiving a digital signal IN and for outputting a delayed digital signal OUT is shown in FIG.7. In CMOS technology, the delay circuit may be implemented as a chain of delay cells 11, which input IN is fed with the digital baseband signal BB. Each delay cell 12 comprises of two inverters connected in series as shown on top of the figure. The signal at the output of a delay cell is, thus, a non-inverted copy of the input signal delayed with a unit delay Td. The unit delay Td defines the accuracy (precision) with which the amount of delay can be tuned to a specified value. The unit delay Td depends on the technology. For a scaled CMOS technology as 40nm or 28nm, the unit delay Td is less than 20ps. The amount of delay to be added to the digital signal may be controlled with a multiplexor 13 as follows. Each input of the multiplexer 13 receives a signal from the output of each respective delay cell 12. The number of the delay cells 12 in the chain 11 defines the total amount of delay T introduced to the digital signal. For example, the digital signal at the output of the Nth delay cell is delayed with T=N*Td. By controlling which signal at the input of the multiplexor is passed to its output, a specific delayed version of the digital signal may be selected. According to a control signal ctrl, the multiplexor selects an appropriate input signal to provide a signal rotated over 120 degrees.

Another possible way to control the amount of delay added to the digital signal, would be with a delay locked loop (DLL). In this case, the delay circuit may be implemented as a cascade of 3*k delay cells. The delay can be tuned close to the desired value by locking the total delay to the Bit Rate (clock frequency). In a locking condition each group of k delay cells will have a delay of 1/3 of the bit period.

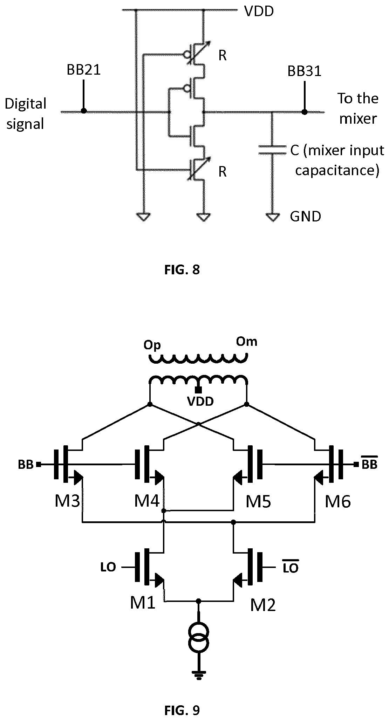

In another embodiment, the filtering means 21,22 may be passive low-pass filters (RC filters). Implementing the filters in a passive form leads to a more linear and less noisy filter's implementation than for active filters. FIG.8 shows an example implementation of a passive low-pass filter implemented in CMOS. In this case, the filter is embedded in a driver circuit that controls the switches of the mixer (its non-linear input). The resistors R acts as degeneration and connects the inverter pair (M7, M8) to VDD and GND, respectively. As a filter capacitance C, the mixer's input capacitance is used. The low-pass filters 21,22 may be tuneable filters. Tuning may be needed, for example, to adjust the pole of the filter and place it in the desired position over process corners. The resistors R, may be implemented, as an array of parallel PMOS and an array of parallel NMOS transistors to allow for tuneability of the filter. By switching on or off transistors in each respective resistive array, the effective resistance R, and respectively the degenerative resistance of the filter is changed. A control circuit, e.g. the baseband processor, may be used for the tuning of the degenerative resistance for a desired bandwidth.

In a further embodiment, as shown in FIG.9, each mixer means 31,32 may be implemented as a passive mixer with an LC resonant load placed at terminals Op and Om. In this implementation, the baseband signal is applied at the non-linear (transconductance) input, that is at the input of transistors M3 to M6, and the local oscillator LO signal is applied at the linear (switching) input of the mixer - at the input of transistors M1 and M2. By feeding the LO signal to the mixer's linear input LO,$\overline{\text{LO}}$, a local oscillator signal with a small amplitude may be used. The power efficiency of the mixer itself and the LO path is increased, as the need of additional buffering circuitry for amplifying the LO signal (which increases with the increase in an operation frequency) to switch the mixer is avoided. This is beneficial, as for LO frequency approaching the cut off of the transistors and in a low voltage supply technology like CMOS, achieving very high swings requires the usage of inductors with high quality factor and is very power hungry. Preferably, the mixing means 31,32 may be implemented as a Gilbert-cell mixer.

By introducing a filter at the switching input of each respective mixer, the mixer switches M3-M6 are not acting like ideal switches being alternatively switched on and off. This means, there are fractions of time in which both the transistors M3 and M6 (and M4 and M5) are on. This may slightly affect output noise and linearity with respect to the other mixer's input. However, for a radio device operating at mm-waves, a higher noise figure and lower linearity is tolerated.

In other embodiments, the circuit 10 is arranged for performing a BPSK modulation. Furthermore, the circuit 10 is particularly suitable for operating at mm-waves. More specifically, the modulation circuit is suitable for 79 GHz radar applications.

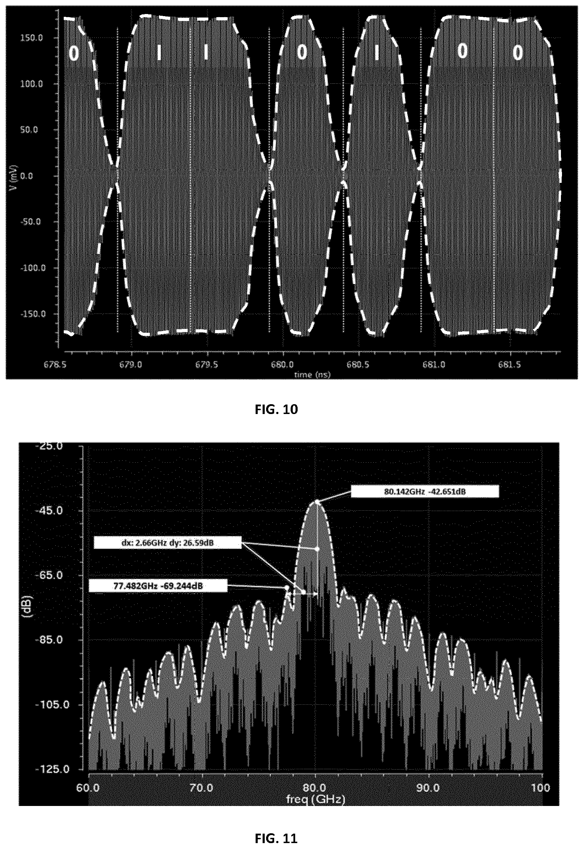

Simulation results using the proposed circuit 10 implemented with Gilbert-cell mixers with an LC resonator tank with a quality factor of about 5, fed modulating a carrier frequency of 83 GHz with a pseudo random base band digital sequence (0110100) with a 2Gps rate, were performed to demonstrate its efficiency. The simulations results were done in Cadence MMSIM for a 28nm CMOS implementation. FIG.10 shows the modulated signal at the output of the proposed circuit 10. Differently from an ideal BPSK, the modulated signal herein has a smooth phase transition from 0 to 180 degrees and vice versa. This smooth phase transition in the time domain signal is equivalent to reduction of the spectral side lobe in the frequency domain. FIG.11 shows the spectrum of the modulated signal of FIG.10, where it is clearly shown that the side lobes were suppress and the signal is compliant with the emission standards and regulations. For example, the power of the main lobe, located at 80.14GHz, is maintained close to its maximum -42.65dBm, while for example the closest side lobe on the left, located at 77.46GHz, has a power of -69.24dBm, which is 26dBm lower than the power of the main lobe.

The present disclosure also relates to a method for suppressing energy content of spectral side lobes outside an intended operational bandwidth in a modulated radio frequency signal. As explained previously, the spectral side lobes in the modulated signal are due to high frequency content present in the baseband signal. The proposed method uses a harmonic rejection at baseband. The method, thus, receives a digital baseband signal BB and generates a radio frequency signal RF with suppressed energy of spectral side lobes while maintaining the energy of the main lobe.

The digital baseband BB signal is applied to two signal paths P1,P2 wherein the baseband signal is up-converted to radio frequency. The implementation of the two signal paths are essentially kept the same, with the difference that in the second signal path P2 the baseband signal BB is delayed. In the first signal path P1, the baseband signal BB is up-converted (mixed) by mixer 31 with a local oscillator signal LO to generate a first radio frequency signal RF1. In the second signal path P2, however, the baseband signal BB is first delayed by the delay circuit 1 and then mixed with the same local oscillator signal LO in mixer 32 to generate a second radio frequency signal RF2. Two modulated radio frequency signals RF1,RF2 with a delay with respect to each other are thus obtained. The radio signals RF1,RF2 are afterwards combined to form the radio frequency signal RF.

In one embodiment, in each signal path P1,P2 the baseband signal BB21,BB22 are filtered before up-conversion. In this embodiment, the baseband signal in the first signal path P1 is first filtered by filtering means 21 and then mixed with the local oscillator signal LO to generate the first radio frequency signal RF1. And, in the second signal path P2, the baseband signal is first delayed, then filtered by filtering means 22 and mixed with the same LO signal to generate the second radio frequency signal RF2. Similarly, the two signal RF1,RF2 are combined to form the radio frequency signal RF.

Furthermore, the present disclosure relates to a radio device and to a network system comprising a circuit 10 as described in any of the previous embodiments.

**Claims**

1. A circuit (10) configured to :

- receive a digital baseband signal (BB) and feed the same digital baseband signal to a first and a second signal path (P1,P2), the first signal path (P1) comprising a first mixing means (31), the second signal path (P2) comprising a delay circuit (1) arranged for delaying the digital baseband signal (BB) and a second mixing means (32), the first and the second mixing means receiving a same local oscillator signal (LO), and respectively providing a first and a second radio frequency signal (RF1,RF2) with a delay with respect to each other; and
- generate a radio frequency signal (RF) by combining the first and second radio frequency signals (RF1,RF2), **characterized in that** the delay circuit (1) has a delay of one third of a bit period of the digital baseband signal (BB).

2. A circuit (10) according to claim 1, wherein each signal path (P1,P2) further comprises a filtering means (21,22) configured to output a first and a second filtered baseband signals (BB31,BB32) with a delay with respect to each other.

3. A circuit (10) according to claim 2, wherein the filtering means (21,22) are a passive low-pass filter.

4. A circuit (10) according to any of the previous claims, wherein the first and the second mixing means (31,32) are passive mixing means.

5. A circuit (10) according to any of the previous claims configured to perform a BPSK modulation.

6. A circuit (10) according to any of the previous claims configured to operate at millimeter waves.

7. A method comprising:

- receiving a digital baseband signal (BB);
- mixing the digital baseband signal (BB) with a local oscillator signal (LO) thereby generating a first radio frequency signal (RF1);
- delaying and mixing the digital baseband signal (BB) with the local oscillator signal (LO) thereby generating a second radio frequency signal (RF2) ; and
- generating a radio frequency signal (RF) by combining the first and second radio frequency signals (RF1,RF2), **characterized in that** the step of delaying comprises delaying with a delay of one third of a bit period of the digital baseband signal (BB).

8. A method according to claim 7, further comprising filtering the digital baseband signal (BB) before mixing with the local oscillator signal (LO).

9. A radio device comprising a circuit (10) according to claims 1 to 6.

10. A network system comprising a radio device according to claim 9.


**Patentansprüche**

1. Schaltung (10), ausgebildet zum:

- Empfangen eines digitalen Basisbandsignals (BB) und Zuführen des digitalen Basisbandsignals zu einem ersten und einem zweiten Signalpfad (P1, P2), wobei der erste Signalpfad (P1) eine erste Mischeinrichtung (31) umfasst, wobei der zweiten Signalpfad (P2) eine Verzögerungsschaltung (1), angeordnet zum Verzögern des digitalen Basisbandsignals (BB), und eine zweite Mischeinrichtung (32) umfasst, wobei die erste und die zweite Mischeinrichtung dasselbe lokale Oszillatorsignal (LO) empfangen und jeweils ein erstes und ein zweites Funkfrequenzsignal (RF1, RF2) mit einer Verzögerung in Bezug zueinander bereitstellen; und
- Erzeugen eines Funkfrequenzsignals (RF) durch Kombinieren des ersten und des zweiten Funkfrequenzsignals (RF1, RF2),

**dadurch gekennzeichnet, dass**
die Verzögerungsschaltung (1) eine Verzögerung von einem Drittel einer Bitperiode des digitalen Basisbandsignals (BB) aufweist.

2. Schaltung (10) nach Anspruch 1, wobei jeder Signalpfad (P1, P2) weiterhin Filtereinrichtungen (21, 22) aufweist, die ausgebildet sind zum Ausgeben eines ersten und eines zweiten gefilterten Basisbandsignals (BB31, BB32) mit einer Verzögerung in Bezug zueinander.

**3.** Schaltung (10) nach Anspruch 2, wobei die Filtereinrichtungen (21, 22) passive Tiefpassfilter sind.

**4.** Schaltung (10) nach einem der vorhergehenden Ansprüche, wobei die erste und die zweite Mischeinrichtung (31, 32) passive Mischeinrichtungen sind.

**5.** Schaltung (10) nach einem der vorhergehenden Ansprüche, ausgebildet zum Ausführen einer BPSK-Modulation.

**6.** Schaltung (10) nach einem der vorhergehenden Ansprüche, ausgebildet zum Betrieb bei Millimeter-Wellen.

**7.** Verfahren, umfassend:

- Empfangen eines digitalen Basisbandsignals (BB);
- Mischen des digitalen Basisbandsignals (BB) mit einem lokalen Oszillatorsignal (LO), dabei Erzeugen eines ersten Funkfrequenzsignals (RF1);
- Verzögern und Mischen des digitalen Basisbandsignals (BB) mit dem lokalen Oszillatorsignal (LO), dabei Erzeugen eines zweiten Funkfrequenzsignals (RF2); und
- Erzeugen eines Funkfrequenzsignals (RF) durch Kombinieren des ersten und des zweiten Funkfrequenzsignals (RF1, RF2),

**dadurch gekennzeichnet, dass**
der Schritt des Verzögerns Verzögern mit einer Verzögerung von einem Drittel einer Bitperiode des digitalen Basisbandsignals (BB) umfasst.

**8.** Verfahren nach Anspruch 7, weiterhin umfassend Filtern des digitalen Basisbandsignals (BB) vor dem Mischen mit dem lokalen Oszillatorsignal (LO).

**9.** Funkvorrichtung, umfassend eine Schaltung (10) nach den Ansprüchen 1 bis 6.

**10.** Netzwerksystem, umfassend eine Funkvorrichtung nach Anspruch 9.


**Revendications**

**1.** Circuit (10) configuré pour :

- recevoir un signal de bande de base numérique (BB) et acheminer le même signal de bande de base numérique à un premier et un second trajet de signal (P1, P2), le premier trajet de signal (P1) comprenant un premier moyen de mélange (31), le second trajet de signal (P2) comprenant un circuit de retard (1) agencé pour retarder le signal de bande de base numérique (BB) et un second moyen de mélange (32), le premier et le second moyen de mélange recevant un même signal d'oscillateur local (LO), et fournissant respectivement un premier et un second signal de fréquence radio (RF1, RF2) avec un retard de l'un par rapport à l'autre ; et
- générer un signal de fréquence radio (RF) en combinant le premier et le second signal de fréquence radio (RF1, RF2),

**caractérisé en ce que** le circuit de retard (1) a un retard d'un tiers d'une période du bit du signal de bande de base numérique (BB).

**2.** Circuit (10) selon la revendication 1, dans lequel chaque trajet de signal (P1, P2) comprend en outre un moyen de filtrage (21, 22) configuré pour délivrer un premier et un second signal de bande de base filtré (BB31, BB32) avec un retard de l'un par rapport à l'autre.

**3.** Circuit (10) selon la revendication 2, dans lequel les moyens de filtrage (21, 22) sont des filtres passe-bas passifs.

**4.** Circuit (10) selon l'une quelconque des revendications précédentes, dans lequel le premier et le second moyen de mélange (31, 32) sont des moyens de mélange passifs.

**5.** Circuit (10) selon l'une quelconque des revendications précédentes configuré pour effectuer une modulation BPSK.

**6.** Circuit (10) selon l'une quelconque des revendications précédentes configuré pour opérer en ondes millimétriques.

**7.** Procédé comprenant :

- la réception d'un signal de bande de base numérique (BB) ;
- le mélange du signal de bande de base numérique (BB) avec un signal d'oscillateur local (LO) en générant de la sorte un premier signal de fréquence radio (RF1) ;
- le retardement et le mélange le signal de bande de base numérique (BB) avec le signal d'oscillateur local (LO) en générant de la sorte un second signal de fréquence radio (RF2) ; et
- la génération d'un signal de fréquence radio (RF) en combinant le premier et le second signal de fréquence radio (RF1, RF2),

**caractérisé en ce que** l'étape de retardement comprend le retardement avec un retard d'un tiers d'une période du bit du signal de bande de base numérique (BB).

**8.** Procédé selon la revendication 7, comprenant en outre le filtrage du signal de bande de base numérique (BB) avant le mélange avec le signal d'oscillateur local (LO).

**9.** Dispositif radio comprenant un circuit (10) selon les revendications 1 à 6.

**10.** Système de réseau comprenant un dispositif radio selon la revendication 9.

**FIG. 1**

**FIG. 2**

**FIG. 3**

**FIG. 4**

**FIG. 5A**

**FIG. 5B**

**FIG. 5C**

**FIG. 6**

**FIG. 7**

**FIG. 8**

**FIG. 9**

FIG. 10

FIG. 11

## REFERENCES CITED IN THE DESCRIPTION

### Patent documents cited in the description

- US 5787126 A
- US 2005068096 A
- EP 0417528 A
- EP 0070695 A
- US 2006019622 A

### Non-patent literature cited in the description

- **S. TROTTA et al.** A 79GHz SiGe-Bipolar Spread-Spectrum TX for Automotive Radar. *IEEE Solid-State Circuits Conference, 2007,* 11 February 2007, 430-613
- **M.A. BELKERDID et al.** Sinusoidal SBPSK Modulation Waveform for UHF SATCOM Channels with Improved Adjacent Channel Emissions. *IEEE Military Communications Conference,* 29 October 2007, 1-7